# EUROPÄISCHE PATENTANMELDUNG

(11) **EP 4 729 653 A1**
(43) Veröffentlichungstag der Anmeldung: **22.04.2026**
(21) Anmeldenummer: 25208892.7
(22) Anmeldetag: 15.10.2025
(51) Int. Cl.: C23C 16/04, C23C 16/44, C23C 16/455, C23C 16/458, C23C 16/511, H01J 37/32

(54) **HALTE- UND DICHTVORRICHTUNG, PLASMABEHANDLUNGSANLAGE UND VERFAHREN ZUR WARTUNG EINER HALTE- UND DICHTVORRICHTUNG**

(30) Priorität: 18.10.2024 DE 102024130347
(71) Anmelder: KHS GmbH, 44143 Dortmund (DE)
(72) Erfinder: Andersen, Patrick, 44143 Dortmund (DE); Brzezinski, Milosz, 44143 Dortmund (DE); Demirel, Ali Orhan, 44143 Dortmund (DE); Kos, Simon, 44143 Dortmund (DE); Roling, Matthias, 44143 Dortmund (DE); Schetle, Andreas, 44143 Dortmund (DE); Schmidt, Dieter, 44143 Dortmund (DE)
(74) Vertreter: Andrejewski - Honke Patent- und Rechtsanwälte Partnerschaft mbB

(57) **Zusammenfassung**

Die Erfindung betrifft eine Halte- und Dichtvorrichtung (5) mit einem eine Dichtung (7) aufweisenden Dichtungsträger (8) und mit einer in einer Hubbewegung zwischen einer Grundposition und einer Dichtposition gegenüber dem Dichtungsträger (8) verlagerbaren Behälterhalterung (10). Dabei wird die Hubbewegung mittels zumindest eines eine Aufnahme (15) durchgreifenden Führungsbolzens (14) geführt. Erfindungsgemäß ist an dem Führungsbolzen (14) zumindest ein Anschlagstück (17) angeordnet, welches in einer Sperrposition die Hubbewegung begrenzt und in zumindest einer Freigabeposition durch die Aufnahme (15) hindurchgeführt werden kann. Weiterhin betrifft die Erfindung eine Plasmabehandlungsanlage (1) sowie ein Verfahren zum Warten einer Halte- und Dichtvorrichtung (5).

## Beschreibung

Die Erfindung betrifft eine Halte- und Dichtvorrichtung mit einem eine Dichtung aufweisenden Dichtungsträger und mit einer in einer Hubbewegung zwischen einer Grundposition und einer Dichtposition gegenüber dem Dichtungsträger verlagerbaren Behälterhalterung. Dabei wird die Hubbewegung mittels zumindest eines eine Aufnahme durchgreifenden Führungsbolzens geführt. Weiterhin betrifft die Erfindung eine Plasmabehandlungsanlage sowie ein Verfahren zum Warten einer Halte- und Dichtvorrichtung.

Die Erfindung geht von einer gattungsgemäßen Halte- und Dichtvorrichtung aus. Diese ist insbesondere dazu eingerichtet, einen eine Mündung aufweisenden Behälter während eines Behandlungsprozesses zu halten und diesen insbesondere an der Mündung abzudichten. Zweckmäßigerweise finden solche Halte- und Dichtvorrichtung Anwendungen in Prozessen, bei denen der Druck und/oder die Stoffzusammensetzung der Medien innerhalb des Behälters und außerhalb des Behälters voneinander unabhängig gesteuert werden müssen.

Ein bevorzugtes Anwendungsgebiet betrifft hierbei die Plasmabeschichtung. Dabei kann es sich insbesondere um ein Plasma-induziertes PIVCD (plasma induced chemical vapour deposition) handeln. Dabei wird der Umgebungsdruck innerhalb und außerhalb des Behälters abgesenkt, um durch Eintrag von Mikrowellenenergie ein Plasma zünden zu können. Innerhalb und/oder außerhalb des Behälters werden ein oder mehrere Prozessgase eingeleitet, welche unter dem Einfluss des Plasmas Stoffe abscheiden. Diese lagern an den innen- und/oder außenseitigen Oberflächen des Behälters an. Auf diese Weise lassen sich sehr effektiv ein oder mehrlagige Beschichtungen erzeugen.

Ein besonders vielfältiger Anwendungsbereich betrifft dabei die Beschichtung von Lebensmittelbehältern, insbesondere Getränkeflaschen. Durch die Beschichtung können dabei gezielt Barriereeigenschaften für die Permeabilität insbesondere vom Wasserdampf, Sauerstoff und CO₂ eingestellt werden. Die Vorläuferstoffe der Prozessgase enthalten sogenannte Monomere, welche durch die Mikrowellenenergie bzw. das Plasma aufgespalten werden, sodass sich die einzelnen Bestandteile an den Oberflächen ablagern können.

Die Halte- und die Dichtfunktion der gattungsgemäßen Vorrichtung sind funktionell in zwei Baugruppen aufgeteilt: Einerseits ist eine Behälterhalterung vorgesehen, welche eine Aufnahme für den Behälter aufweist. Diese Behälteraufnahme greift üblicherweise an der Mündung bzw. nahe an der Mündung an den Behälter an und kann diesen dadurch reib- kraft- und/oder formschlüssig in Position halten. Die Dichtfunktion wird durch die zweite Baugruppe eines Dichtungsträgers übernommen, welcher zumindest eine Dichtung aufweist.

Während des (Beschichtungs-)Prozesses ist vorgesehen, dass der Behälter zunächst in die Behälterhalterung eingesetzt wird, ohne dass dabei die Mündung des Behälters in Kontakt mit der Dichtung ist. Diese beabstandete Stellung von Dichtungsträger und Behälterhalterung wird auch als Grundposition bezeichnet.

Anschließend werden der Dichtungsträger und die Behälterhalterung aufeinander relativ zu bewegt, sodass die Mündung des Behälters mit der Dichtung in Kontakt tritt und durch diese abgedichtet wird. Diese zweite Stellung wird auch als Dichtposition bezeichnet. In dieser Stellung kann dann der Prozess, insbesondere Plasmabeschichtungsprozess durchgeführt werden.

Abschließend können der Dichtungsträger und die Behälterhalterung wieder zurück in die Grundposition verlagert werden, sodass der Behälter entnommen werden kann. Im Rahmen des üblichen Betriebs ist die Bewegung von Dichtungsträger und Behälterhalterung auf den Bereich zwischen der Grundposition und der Dichtposition beschränkt. Dieser Bereich wird auch als Arbeitsbereich bezeichnet.

Die Erfindung geht weiterhin davon aus, dass die Hubbewegung mittels zumindest eines eine Aufnahme durchgreifenden Führungsbolzens geführt ist. Das Zusammenspiel von Führungsbolzen und Aufnahme ergibt eine mechanische Zwangsführung, welche die Relativbewegung von Dichtungsträger und Behälteraufnahme in dem Arbeitsbereich auf die vorgesehene Hubbewegung einschränkt.

Eine solche gattungsgemäße Halte- und Dichtvorrichtung ist beispielsweise aus DE 10 2022 119 835 A1 bekannt. Dort sind zwei Führungsbolzen an dem Dichtungsträger angeordnet, welche zugeordnete Aufnahmen an der Behälterhalterung durchgreifen. Die Beweglichkeit zwischen der Grundposition und der Dichtposition wird durch zwei klappbare Eingriffshaken begrenzt, welche in zugeordnete Aussparungen der Führungsbolzen eingreifen. Dabei ist jedoch von Nachteil, dass die mechanische Stabilität der Führungsbolzen durch die Aussparungen geschwächt wird. Bei einer unvorhergesehenen starken Belastung - insbesondere aufgrund einer Kollision eines Behälters in der Maschine, eines sogenannten Flaschencrashs - können die Führungsbolzen verformt werden.

Auch wird durch die seitlichen Aussparungen insbesondere ein Knicken bei einer starken Beanspruchung begünstigt. Ein verformter Führungsbolzen führt jedoch zu einer eingeschränkten bis gänzlich unterbundenen Beweglichkeit der Halte- und Dichtvorrichtung. Dies macht einen vollständigen Austausch der verformten Bauteile erforderlich, was zu einem langen Stillstand der Maschine führt.

Vor diesem Hintergrund liegt der Erfindung die Aufgabe zugrunde, die Stabilität der gattungsgemäßen Halte- und Dichtvorrichtung zu erhöhen. Gleichzeitig soll die Wartung vereinfacht werden.

Gegenstand der Erfindung und Lösung dieser Aufgabe ist eine Halte- und Dichtvorrichtung nach Anspruch 1, eine Plasmabehandlungsanlage nach Anspruch 12 sowie ein Verfahren zur Wartung nach Anspruch 14. Bevorzugte Ausgestaltungen sind jeweils in den abhängigen Unteransprüchen angegeben.

Ausgehend von der gattungsgemäßen Halte- und Dichtvorrichtung ist erfindungsgemäß an dem Führungsbolzen zumindest ein Anschlagstück angeordnet, welches in einer Sperrposition die Hubbewegung begrenzt und in zumindest einer Freigabeposition durch die Aufnahme hindurchgeführt werden kann. Dadurch können der Dichtungsträger und die Behälterhalterung in der Freigabeposition über den vorgesehenen Arbeitsbereich zwischen der Grundposition und der Dichtposition hinaus bewegt und insbesondere voneinander getrennt werden. Im Regelbetrieb nimmt das Anschlagstück die Sperrposition ein und begrenzt so die Hubbewegung, sodass diese insbesondere nicht aus dem Arbeitsbereich heraus geführt werden kann.

Zweckmäßigerweise sind der Dichtungsträger und die Behälterhalterung federbelastet gegeneinander vorgespannt. Dabei wird durch mechanischen Kontakt mit dem Anschlagstück ein erster Anschlag definiert, welcher insbesondere mit der Grundposition identisch sein kann. Ein gegenüberliegender zweiter Anschlag - insbesondere der Dichtposition - kann durch mechanischen Kontakt zwischen dem Dichtungsträger und der Behälterhalterung oder aber auch zwischen einem in der Behälterhalterung aufgenommenen Behälter und der Dichtung erfolgen.

Im Rahmen der Erfindung können sich sowohl die Freigabeposition als auch die Sperrposition sowohl auf diskrete und eindeutige Positionen als auch auf kontinuierliche Bereiche beziehen. In letzterem Fall gibt es bevorzugt eine eindeutige und besonders gekennzeichnete Position, innerhalb des Freigabe- bzw. Sperr-Bereichs.

Gemäß einer bevorzugten Ausgestaltung ist die Hubbewegung zwischen der Grundposition und der Dichtposition in einer Hubrichtung linear geführt. Das Anschlagstück ist dabei durch eine Drehbewegung um eine parallel zu der Hubrichtung verlaufende Drehachse zwischen der Freigabeposition und der Sperrposition beweglich. Eine derartige Ausgestaltung ermöglicht eine einfache und leicht zu bedienende Möglichkeit, das Anschlagstück zwischen der Sperrposition und der Freigabeposition einzustellen. Weiterhin ist die korrekte Positionierung für einen Bediener anhand der Ausrichtung eindeutig erkennbar.

Vorzugsweise ist das Anschlagstück durch zumindest eine Arretierung in der Freigabeposition und/oder der Sperrposition gehalten. Durch die Arretierung ist das Anschlagstück in der Sperrposition und/oder der Freigabeposition durch Kraftwirkung verrastet und/oder formschlüssig gesperrt.

Bevorzugt wird das Anschlagstück zumindest in der Sperrposition gehalten, um im Betrieb eine unkontrollierte Verlagerung oder ein Auseinanderfallen von der Behälterhalterung und dem Dichtungsträger zu verhindern. Um eine leichte Montage und Demontage zu ermöglichen, ist darüber hinaus bevorzugt auch die Arretierung in der Freigabeposition wirksam.

Die Arretierung ist insbesondere Kraft-beaufschlagt ausgebildet. Dabei kann die jeweilige arretierte Position durch Kraftaufwand verlassen werden. Alternativ oder zusätzlich können auch Sperrmittel vorgesehen sein, welche ein Verlassen der jeweiligen Position durch formschlüssigen Eingriff verhindert.

Gemäß einer ersten bevorzugten Ausgestaltung weist der Führungsbolzen zumindest eine Rastfläche auf, welche mit zumindest einem elastischen Rast- und/oder Sperrelement zusammenwirkt. Die Rastfläche ist asymmetrisch bezüglich einer Bewegung zwischen der Sperrposition und der Freigabeposition, insbesondere nicht-rotationssymmetrisch um eine etwaige Drehachse, ausgebildet, um die das Anschlagstück z. B. um den Führungsbolzen verdrehbar gelagert ist.

Vorzugsweise weist der Führungsbolzen eine asymmetrische Außenfläche auf, welche die Rastfläche bildet. Damit wird die Rastfläche kompakt und einfach in den erfindungsgemäßen Aufbau integriert.

Gemäß einer ersten bevorzugten Ausgestaltung kann das Sperrelement als Federstift ausgebildet sein, welcher außenseitig auf die Rastfläche aufgedrückt wird. Alternativ oder zusätzlich kann auch eine ein Schraubelement, z. B. eine Madenschraube, verwendet werden, um eine dauerhafte Verrastung zu ermöglichen.

Gemäß einer alternativen Ausgestaltung umgreift das Anschlagstück zumindest teilweise formschlüssig eine asymmetrische Außenfläche, welche insbesondere an dem Führungsbolzen ausgebildet sein kann. Das Anschlagstück ist dabei zumindest abschnittsweise verformbar ausgebildet, sodass eine Bewegung, insbesondere Drehung ermöglicht wird. Insbesondere kann das Anschlagstück seitlich geschlitzt ausgebildet sein, sodass dieses sich bei einer Bewegung öffnet und nach Erreichen einer vorgesehenen Position (insbesondere Sperrposition bzw. Freigabeposition) wieder elastisch zurückstellt und einen Formschluss herstellt.

Die Möglichkeiten einer Verrastung im Rahmen der Erfindung umfasst jeweils auch die kinematische Umkehr. Dabei ist an dem Anschlagstück jeweils zumindest eine asymmetrische Rastfläche angeordnet/ausgebildet, welche mit einem zumindest einem zugeordneten Rast- und/oder Sperrelement an dem Führungsbolzen zusammenwirkt.

Gemäß einer bevorzugten Ausgestaltung der Erfindung ist das Anschlagstück verliersicher an dem Führungsbolzen gehalten. Dabei wird durch einen Formschluss gewährleistet, dass das Anschlagstück nicht von dem Führungsbolzen getrennt werden kann. Der Formschluss kann durch den Führungsbolzen und das Anschlagstück selbst hergestellt oder mittels eines Fixierungselements auf dem Führungsbolzen gehalten ist.

Gemäß einer besonders bevorzugten Ausgestaltung ist das Anschlagstück lösbar und/oder austauschbar an dem Führungsbolzen gehalten. Dies kann beispielsweise durch einen elastischen Sprengring als Fixierungselement geschehen. Der Sprengring kann beispielsweise so ausgestaltet sein, dass er in eine zugeordnete Nut des Führungsbolzens senkrecht zu einer Längserstreckungsachse eingeschoben werden kann. Durch elastische Rückstellkräfte wird der Sprengring an dem Führungsbolzen gehalten und verhindert so ein Herausziehen des Anschlagstücks von dem Führungsbolzen in Richtung der Längserstreckungsachse. Im Gegensatz zu einer Bajonett-Verriegelung oder Schraubverbindung können das Anschlagstück und der Führungsbolzen durch die Bewegung zwischen der Sperrposition und der Freigabeposition nicht versehentlich voneinander getrennt werden, sodass der dauerhafte Zusammenhalt gewährleistet ist.

Die Aufnahme liegt mit zumindest einer inneren Führungsfläche flächig an der äußeren Führungsfläche an. Die Verbindung zwischen der äußeren Führungsfläche und der inneren Führungsfläche bilden somit ein Gleitlager für die Hubbewegung. Während der Hubbewegung zwischen der Grundposition und der Dichtposition bleiben die innere Führungsfläche und die äußere Führungsfläche in dauerhaftem Kontakt.

Besonders bevorzugt weist der Führungsbolzen eine äußere Führungsfläche auf, innerhalb derer der Führungsbolzen als Vollbolzen mit konstantem Querschnitt ausgebildet ist. Das durch die äußere Führungsfläche berandete Volumen ist damit vollständig durch das Material des Führungsbolzens ausgefüllt, was zu einer bestmöglichen Stabilität führt. Dadurch, dass die innere Führungsfläche durchgängig an der äußeren Führungsfläche geführt ist, wird dabei auch eine optimale Krafteinleitung in den Führungsbolzen gewährleistet.

Gemäß einer bevorzugten Ausgestaltung der Erfindung ist der Führungsbolzen an dem Dichtungsträger angeordnet und die Aufnahme in der Behälterhalterung ausgebildet. Dies ist insbesondere dann von Vorteil, wenn der Dichtungsträger ortsfest an einer übergeordneten Maschine wie beispielsweise einer Plasmabehandlungsanlage bzw. deren Plasmabehandlungsstation vorgesehen ist. Der Dichtungsträger ist üblicherweise an Rohrleitungen angeschlossen, sodass dieser zweckmäßigerweise unbeweglich ausgeführt ist. Vorteilhafterweise sind mehrere Führungsbolzen an dem Dichtungsträger ausgebildet, welche jeweils eine zugeordnete Aufnahme der Behälterhalterung durchgreifen und insbesondere jeweils ein Anschlagstück zum Begrenzen der Hubbewegung aufweisen.

Besonders bevorzugt ist der Führungsbolzen austauschbar ausgestaltet. Dazu ist dieser lösbar an dem Dichtungsträger befestigt und kann im Verschleißfall durch einen neuen Führungsbolzen identischer Ausgestaltung ausgewechselt werden. Zweckmäßigerweise ist der Führungsbolzen aus einem widerstandsfähigen Material, wie z. B. Edelstahl, gebildet. Dies ermöglicht eine besonders hohe Verschleißfestigkeit.

Alternativ kann der Führungsbolzen auch aus einem weicheren Material gebildet sein als die ihn im zusammengesetzten Zustand umgebende Aufnahme. Dadurch wird der Verschleiß an dem austauschbaren Führungsbolzen konzentriert.

Alternativ oder zusätzlich ist der Führungsbolzen an der Behälterhalterung angeordnet und die Aufnahme in dem Dichtungsträger ausgebildet. Dies hat den Vorteil, dass der Führungsbolzen gemeinsam mit der Behälteraufnahme - nach dem Positionieren des Anschlagstücks in der Freigabestellung - entnommen werden kann. Somit kann zur besonders schnellen Wartung ein direkter Austausch von Behälterhalterung mit dem daran befestigten Führungsbolzen erfolgen. Zusätzlich kann der Führungsbolzen auch lösbar und austauschbar mit der Behälterhalterung verbunden sein.

Vorzugsweise weist das Einschlagstück ein oder mehrere insbesondere radial über den Führungsbolzen nach außen vorstehende Vorsprünge auf, welche in der Sperrposition an eine die Aufnahme umgebende Anschlagfläche anschlagen und welche in der Freigabeposition in der Ausnehmung ausgebildeten Durchbrüchen fluchten. Insbesondere wird die Umstellung zwischen der Sperrposition und der Freigabeposition durch eine insbesondere werkzeuglose Verlagerung realisiert - insbesondere translatorisch und/oder rotatorisch. Dies kann bevorzugt senkrecht zu der Hubbewegung erfolgen.

Dadurch, dass die Vorsprünge in der Freigabeposition in Flucht mit den Durchbrüchen gebracht werden, fällt die Anschlags-Wirkung weg, sodass der Dichtungsträger und die Behälterhalterung über den Anschlag hinaus bewegt und insbesondere voneinander getrennt werden können.

Besonders bevorzugt ist das Anschlagstück derart ausgebildet, dass es ausschließlich in den Vorsprüngen über den Führungsbolzen nach außen vorsteht - d. h. insbesondere radial außen von einer äußeren Führungsfläche, welche von dem Führungsbolzen gebildet wird. Indem die nach außen vorstehenden Bereiche auf das funktionelle Minimum beschränkt werden, kann eine besonders gute Handhabbarkeit gewährleistet und Material eingespart werden. Der Führungsbolzen kann z. B. ebenfalls eine Grundform mit Ausbuchtungen aufweisen, welche sich in die Durchbrüche hinein erstrecken.

Besonders bevorzugt sind umlaufend mehrere Vorsprünge ausgebildet. Dabei kann es sich gemäß einer bevorzugten Variante und genau zwei und insbesondere einander gegenüberliegend ausgebildete Vorsprünge handeln. Diese korrespondieren mit zwei an der Aufnahme entsprechend ausgebildeten Durchbrüchen. Das Verstellen des Anschlagstücks zwischen der Freigabeposition und der Anschlagposition kann damit durch eine Drehung von insbesondere 90° erzielt werden. Bei einer solchen Ausgestaltung mit zwei gleichartigen Paaren aus Vorsprung und Durchbruch bestehen zwei um 180° versetzte Möglichkeiten einer Freigabeposition.

Um eine gleichmäßigere Lastverteilung des Anschlagstücks herbeizuführen, können auch drei oder mehr Vorsprünge vorgesehen sein, welche am Umfang des Führungsbolzens, insbesondere äquidistant verteilt angeordnet sind. Um eine ausreichende Stabilität am Umfang der Ausnehmung abseits der Durchbrüche zu gewährleisten, sind jedoch besonders bevorzugt nicht mehr als vier Vorsprünge vorgesehen.

In einer möglichen Ausführungsform der Erfindung sind die Vorsprünge durch ihre Position am Umfang des Anschlagstücks und/oder ihre Abmessung jeweils einem bestimmten Durchbruch zugeordnet. Entsprechend existiert nur eine einzige, eindeutige Freigabeposition, wenn jeweils jeder dieser Vorsprünge mit dem ihm zugeordneten Durchbruch fluchtet. Dies kann beispielsweise erreicht werden, wenn der Winkel zwischen zwei benachbarten Vorsprüngen von der gleichen Winkelteilung (z. B. 180° bei zwei Vorsprüngen bzw. 120° bei drei Vorsprüngen) abweicht. Eine solche Gestaltung führt dazu, dass ein Verlassen des Arbeitsbereichs in nur einer eindeutigen Freigabeposition möglich ist. Dies stellt eine zusätzliche Sicherung im Betrieb dar.

Zweckmäßigerweise sind der Führungsbolzen und/oder das Anschlagstück aus Edelstahl gebildete. Diese können jedoch auch aus ein oder mehreren dielektrischen Materialien, insbesondere Kunststoffen gebildet sein. Die Dielektrizität ist eine wichtige Eigenschaft bei einem vorgesehenen Einsatz in einer Plasmabehandlungsstation, da anderenfalls Störungen eines das Plasma bereitstehenden Mikrowellenfeldes entstehen können. Diese weisen insbesondere im Mikrowellen-Bereich zwischen 1 GHz und 10 GHz eine relative Permittivität ε_{R} von nicht mehr als 10 auf.

Gemäß einer besonders bevorzugten Ausgestaltungsform der Erfindung liegt der Führungsbolzen mit einem ersten Material, ausgewählt aus der Gruppe Polyethylen oder Polyetheretherketon (PEEK) an einem die Aufnahme ausbildenden Teil mit einem von dem ersten Material verschiedenen zweiten Material, ebenfalls ausgewählt aus der Gruppe Polyethylen oder Polyetheretherketon (PEEK) an. Besonders bevorzugt ist der Führungsbolzen zu zumindest 90 Gew.-%, insbesonder vollständig aus dem ersten Material gebildet und/oder dass die Aufnahme ausbildenden Teil zu zumindest 90 Gew.--%, insbesondere vollständig aus dem zweiten Material gebildet.

Bevorzugt ist ein das erste Material und/oder das zweite Material bildende Polyethylen als hochmolekulares Polyethylen mit einer mittleren Molmasse von zumindest 500.000 g/mol ausgebildet. Ganz besonders bevorzugt ist das erste Material oder das zweite Material als PE-HMW oder PE500 mit einer mittleren Molmasse zwischen 500.000 g/mol und 1.000.000 g/mol ausgestaltet.

Vorzugsweise bildet der Führungsbolzen eine erste Führungsfläche aus, mit der der Führungsbolzen bei einer Hubbewegung zwischen der Grundposition und der Dichtposition an einer zweiten, die Aufnahme berandenden Führungsfläche anliegt. Insbesondere entspricht die erste Anlagefläche der zuvor beschriebenen äußeren Führungsfläche und/oder die zweite Anlagefläche der inneren Führungsfläche wie zuvor beschrieben.

Die bevorzugte Materialpaarung aus einem hochmolekularen PE (insbesondere PE500) und PEEK ist vorteilhaft, da beide Materialien ähnliche dielektrische Eigenschaften aufweisen. Gleichzeitig sind die mechanischen Eigenschaften ebenfalls ähnlich, jedoch nicht identisch. So weist das Polyethylen eine geringere Härte und damit Verschleißbeständigkeit auf. Der Verschleiß des Gleitlagers zwischen dem Führungsbolzen und der diesen umgreifenden Aufnahme wird somit gezielt auf das aus hochmolekularem PE gebildete Teil gelenkt - insbesondere den Führungsbolzen. Dies ist deshalb von Vorteil, da der Führungsbolzen in der Regel leichter austauschbar ist als das die Aufnahme ausbildende Umgebungsteil.

Die Erfindung betrifft auch eine Plasmabehandlungsanlage mit einer Plasmabehandlungsstation und mit einer an die Plasmabehandlungsstation angeschlossenen Mikrowellenquelle, insbesondere einem Magnetron. Erfindungsgemäß ist an der Plasmabehandlungsstation eine zuvor beschriebene Halte- und Dichtvorrichtung angeordnet. Diese ermöglicht durch das Anschlagstück ein besonders leichtes Trennen von Dichtungsträger und Behälterhalterung. Somit wird die Wartung maßgeblich vereinfacht.

Vorzugsweise weist die Plasmabehandlungsstation zumindest eine an die Mikrowellenquelle angeschlossene Kavität auf, welche zwischen einer geschlossenen und einer geöffneten Position bewegt werden kann. Die Halte- und Dichtvorrichtung erstreckt sich zumindest in der geschlossenen Position in die Kavität hinein. Dadurch ist diese dazu eingerichtet, ein Werkstück, insbesondere einen Behälter innerhalb der Kavität zu halten und insbesondere dessen Mündung gegen die Dichtung abzudichten. Hierdurch wird bei einem Plasma-Behandlungsprozess, insbesondere Plasma-Beschichtungsprozess die gezielte Steuerung der Druckverhältnisse und Zusammensetzung der Prozessfluide innerhalb und außerhalb des Behälters ermöglicht.

Weiterhin ist Gegenstand der Erfindung auch ein Verfahren zur Wartung einer zuvor beschriebenen Halte- und Dichtvorrichtung, insbesondere als Teil einer zuvor beschriebenen Plasmabehandlungsanlage. Die Halte- und Dichtvorrichtung ist zum Halten und Abdichtung eines Behälters eingerichtet und umfasst einen eine Dichtung aufweisenden Dichtungsträger sowie eine in einer Hubbewegung zwischen einer Grundposition einer Dichtposition gegenüber dem Dichtungsträger verlagerbare Behälterhalterung zum Halten des Behälters. Die Hubbewegung wird mittels zumindest eines eine Aufnahme durchgreifenden Führungsbolzens geführt.

Erfindungsgemäß ist an dem Führungsbolzen zumindest ein Anschlagstück angeordnet, welches in einer Sperrposition die Hubbewegung begrenzt und in zumindest einer Freigabeposition durch die Aufnahme hindurchgeführt werden kann. Zur Wartung wird zunächst das Anschlagstück in die Freigabeposition bewegt und der Dichtungsträger und die Behälterhalterung anschließend über die Grundposition und/oder die Dichtposition hinaus bewegt und insbesondere voneinander getrennt. Anschließend werden zur Wartung eine oder mehrere Baugruppen überprüft, gereinigt und/oder ausgetauscht. Bei den Baugruppen kann es sich beispielsweise um die Dichtung oder die Behälterhalterung handeln. Der Dichtungsträger und die Behälterhalterung werden anschließend in eine Position zwischen der Grundstellung und der Dichtungsstellung (jeweils einschließlich) gebracht, sodass der Führungsbolzen die Aufnahme durchgreift und abschließend das Anschlagstück in die Sperrposition bewegt.

Die Erfindung wird nachfolgend anhand von lediglich ein Ausführungsbeispiel darstellenden Figuren erläutert. Es zeigen dabei schematisch:
- Fig. 1: eine schematische Darstellung einer erfindungsgemäßen Plasmabehandlungsanlage,
- Fig. 2: eine perspektivische Darstellung einer erfindungsgemäßen Halte- und Dichtvorrichtung,
- Fig. 3: eine schematische Draufsicht entsprechend Fig. 2,
- Fig. 4A: eine perspektivische Detailansicht eines Führungsbolzens gemäß einer ersten Ausführungsform,
- Fig. 4B: eine Darstellung entsprechend Fig. 4A bei einer alternativen Ausführungsform,
- Fig. 5A: einen Horizontalschnitt durch die Ansicht gemäß Fig. 4A und
- Fig. 5B: einen Horizontalschnitt durch eine Anordnung gemäß Fig. 4B.

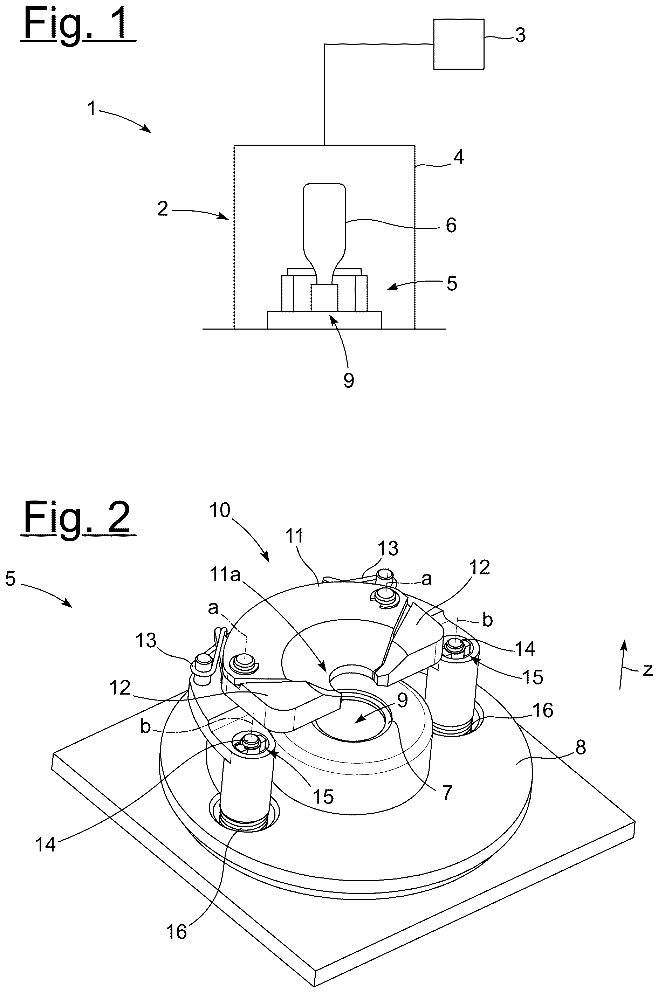

Die Fig. 1 zeigt eine erfindungsgemäße Plasmabehandlungsanlage 1 mit einer Plasmabehandlungsstation 2 und einer an die Plasmabehandlungsstation 2 angeschlossenen Mikrowellenquelle 3. Die Plasmabehandlungsstation 2 weist eine an die Mikrowellenquelle 3 angeschlossene Kavität 4 auf, welche in Fig. 1 schematisch in einer geschlossenen Position dargestellt ist. In die geschlossene Kavität 4 hinein erstreckt sich eine erfindungsgemäße Halte- und Dichtvorrichtung 5, an der ein Behälter 6 aufgenommen ist.

Die Halte- und Dichtvorrichtung 5 zum Halten und Abdichten des Behälters 6 in der Plasmabehandlungsstation 2 ist in größerem Detail in Fig. 2 dargestellt: Diese umfasst einen eine Dichtung 7 aufweisenden Dichtungsträger 8. In dem dargestellten Ausführungsbeispiel wird der Dichtungsträger 8 durch eine ortsfest an der Plasmabehandlungsstation 2 angeordnete Grundplatte gebildet. Zentral innerhalb der Dichtung 7 ist eine Öffnung 9 ausgebildet, durch die insbesondere Prozessgase in das Innere des Behälters 6 eingeleitet werden können.

Die Halte- und Dichtvorrichtung 5 umfasst ferner eine Behälterhalterung 10 zum Halten des Behälters 6, welche in einer Hubbewegung zwischen einer Grundposition und einer Dichtposition gegenüber dem Dichtungsträger 8 verlagert werden kann.

Fig. 2 zeigt dabei die Grundposition zur besseren Sichtbarkeit ohne den Behälter 6. In der Grundposition weisen der Dichtungsträger 8 und die Behälterhalterung 10 zueinander einen größeren Abstand auf als in der Dichtposition, bei der ein an der Behälterhalterung 10 aufgenommener Behälter an der Dichtung 7 dichtend anliegt

Zur Aufnahme des Behälters 6 weist die Behälterhalterung 10 einen eine Behälteraufnahme 11a ausbildenden Träger 11 sowie zwei gegenüber dem Träger 11 bewegliche Halteelemente 12 auf. In dem dargestellten Ausführungsbeispiel sind die beiden Halteelemente als Haltefinger ausgebildet, welche um eine vertikal verlaufende Schwenkachsen a drehbar gehalten sind. Durch rückwärtig an die Halteelemente 12 angreifende elastische Rückstellelemente 13 wird eine Schwenkbewegung in Richtung der Behälteraufnahme 11a bewirkt, sodass ein in die Behälteraufnahme 11a eingelegter Behälter 6 durch Kraftbeaufschlagung der Halteelemente 12 gehalten wird.

Die Behälterhalterung 10 - und gegebenenfalls ein daran gehaltener Behälter 6 - sind in einer Hubbewegung gegenüber dem Dichtungsträger 8 verlagerbar. Dazu ist vorgesehen, dass während eines Plasma-(Beschichtungs-)Prozesses der Behälter 6 zunächst in die Behälterhalterung 10 eingesetzt wird, während diese die in der Figur dargestellte Grundposition einnimmt. In dieser verbleibt zwischen der Mündung des Behälters 6 und der Dichtung 7 in der Vertikalrichtung z ein Abstand, während die Mündung bereits mit der Öffnung 9 innerhalb der Dichtung 7 fluchtet.

Anschließend wird die Behälterhalterung 10 mit dem daran aufgenommenen Behälter 6 auf den Dichtungsträger 8 zubewegt, sodass die Mündung des Behälters 6 mit der Dichtung 7 in Kontakt tritt und damit zwei Volumina innerhalb und außerhalb des Behälters 6 voneinander abteilt. Durch Evakuieren des Innenraumes der Kavität 4 werden Bedingungen hergestellt, unter denen ein Plasma zünden kann, wobei der Druck innerhalb und außerhalb des Behälters 6 aneinander angeglichen wird, um eine ungewollte Verformung des Behälters 6 zu verhindern.

Zumindest eins der beiden Volumina innerhalb oder außerhalb des Behälters 6 wird anschließend mit einem Prozessgas bzw. Gasgemisch gespült, aus dem durch Mikrowellen-induziertes Zünden eines Plasmas innerhalb der Kavität 4 Beschichtungsmoleküle abgespalten werden, die sich an der Oberfläche des Behälters 6 anlagern.

Die unterschiedliche Stoffzusammensetzung des bzw. der Prozessgase und unterschiedliche Charakteristiken beim Eintrag der Mikrowellenenergie können dabei Schichten unterschiedlicher Abmessung und Zusammensetzung erzeugen. Diese können insbesondere in einem mehrstufigen Prozess zu mehrlagigen Beschichtungen kombiniert werden. Beispielsweise wird zunächst eine Haftvermittlerschicht auf das Substrat des Behälters - in der Regel ein Kunststoff, insbesondere Polyethylenterephthalat (PET) - aufgebracht. Die Haftvermittlerschicht wird anschließend mit einer die hauptsächliche Barrierewirkung vermittelnden Barriereschicht überzogen und anschließend durch eine obere Schutzschicht - das sogenannte Topcoating - abgeschlossen und versiegelt.

Zum Entnehmen des behandelten, insbesondere beschichteten Behälters 6 werden die Behälterhalterung 10 und der Dichtungsträger 8 in einer Hubbewegung voneinander entfernt, sodass der Behälter 6 den Kontakt zur Dichtung 7 verliert und mit geringem mechanischen Aufwand aus der Behälterhalterung 10 entnommen werden kann.

Die Hubbewegung ist mittels zweier Führungsbolzen 14 geführt, welche an dem Dichtungsträger 8 angeordnet sind und zugeordnete Aufnahmen 15 der Behälterhalterung 10 durchgreifen. In dem dargestellten Ausführungsbeispiel sind die Führungsbolzen 14 in der Vertikalrichtung z ausgerichtet und ermöglichen so eine lineare Führung der Behälterhalterung 10 an dem Dichtungsträger 8. Die Hubbewegung ist dabei durch zwei Schraubenfedern 16 in der Vertikalrichtung nach oben vorgespannt. Eine Verlagerung aus der dargestellten Grundposition in die Dichtposition erfolgt gegen die Rückstellkraft der Schraubenfedern 16.

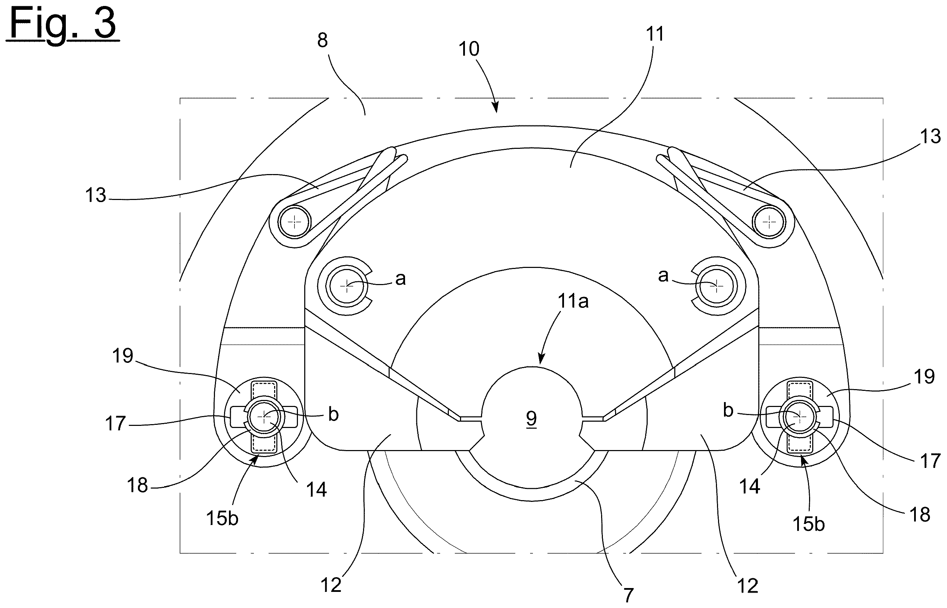

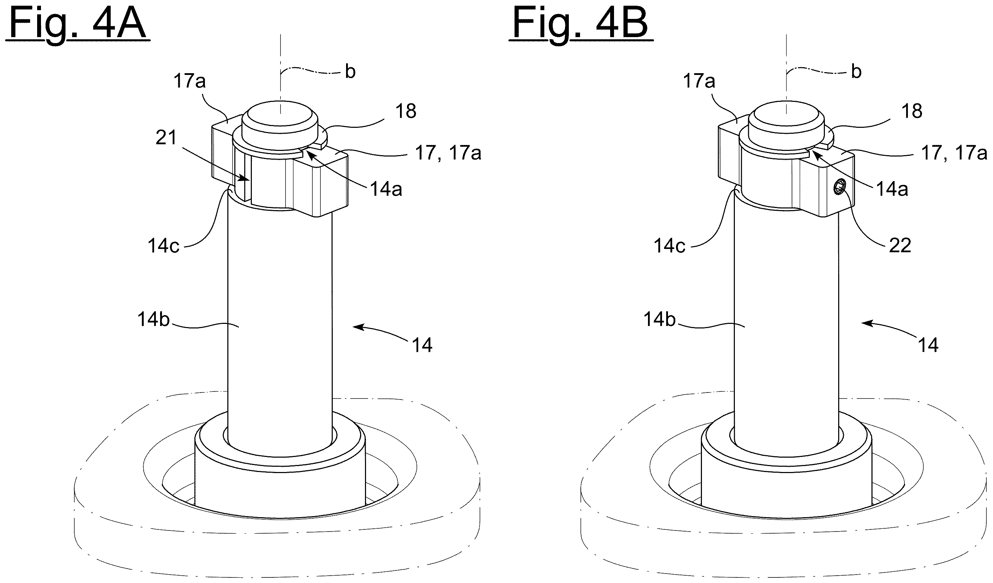

Wie man insbesondere den Figuren 3 und 4A/4B entnehmen kann, ist erfindungsgemäß an den Führungsbolzen 14 jeweils ein Anschlagstück 17 angeordnet, welches in einer - in den Figuren 2 und 3 dargestellten - Sperrposition die Hubbewegung begrenzt und in einer - in den Figuren 4A bis 5B dargestellten - Freigabeposition durch die Aufnahme 15 hindurchgeführt werden kann. Hierdurch ist es möglich, die Behälterhalterung 10 zu Wartungszwecken gänzlich von dem Dichtungsträger 8 zu entfernen und beispielsweise zu reinigen oder durch ein Austauschteil zu ersetzen.

In dem gezeigten Ausführungsbeispiel ist die Richtung, in der der Dichtungsträger 8 und die Behälterhalterung 10 zueinander beweglich geführt sind identisch mit der Vertikalrichtung z. Die beiden Anschlagstücke 17 sind in der gezeigten Ausführungsform durch eine Drehbewegung um eine parallel zu der Hubrichtung bzw. Vertikalrichtung z verlaufende Drehachse b zwischen der Freigabeposition und der Sperrposition beweglich. Dazu ist in Fig. 3 neben der mit durchgezogenen Linien dargestellten Sperrposition auch die Freigabeposition durch eine gestrichelte Linie angedeutet.

Wie man insbesondere den detaillierten Darstellungen der Figuren 4A und 4B entnehmen kann, ist das Anschlagstück 17 verliersicher an dem Führungsbolzen 14 gehalten. Hierzu ist ein Sprengring 18 in eine zugeordnete Aufnahmenut 14a in einer Ebene senkrecht zu der Drehachse b eingesetzt. Dadurch wird ein axiales Abziehen des Anschlagstücks 17 längs der Drehachse b verhindert.

Der Führungsbolzen 14 weist eine äußere zylindersymmetrische Führungsfläche 14b auf, innerhalb derer dieser als Vollbolzen ausgefüllt ist. Das Volumen innerhalb der äußeren Führungsfläche 14b wird vollständig durch das Material des Führungsbolzens 14 ausgefüllt. In axialer Richtung entlang der Drehachse b schließt an die äußere Führungsfläche 14a ein stufenförmiger Rücksprung des Durchmessers an. An der so gebildeten Schulter 14c des Führungsbolzens 14 liegt das Anschlagstück 17 auf und ist durch den Sprengring 18 in axialer Richtung gesichert. Durch diesen Formschluss wird die Beweglichkeit des Anschlagstücks 17 auf eine reine Drehbewegung um die Drehachse b eingeschränkt.

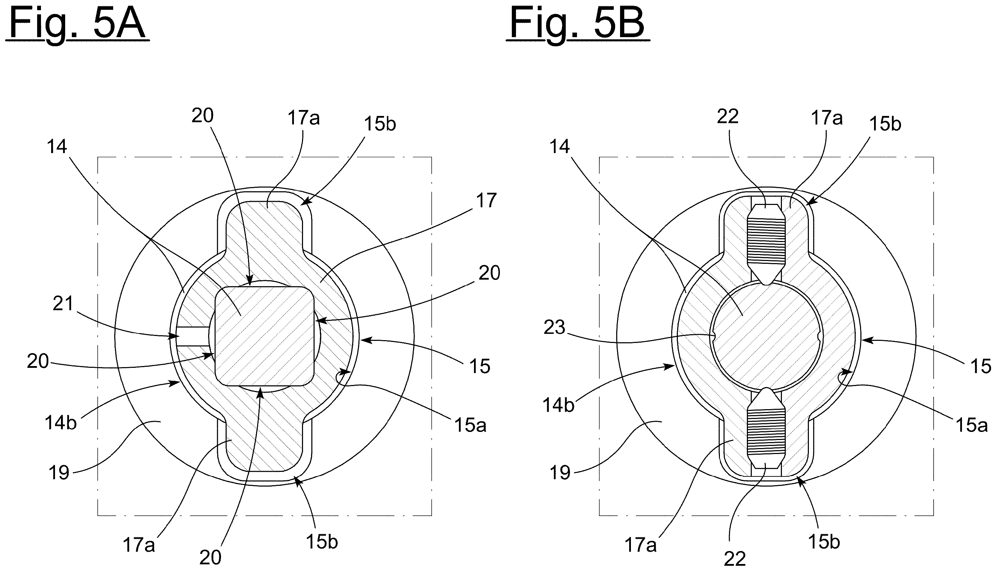

Wie man insbesondere den Darstellungen gemäß Fig. 5A und 5B entnehmen kann, bildet die Aufnahme 15 jeweils zwei innere Führungsflächen 15a, welche ebenfalls zylindersymmetrisch um die Drehachse b ausgebildet sind. Die beiden sich gegenüberliegenden inneren Führungsflächen 15a bilden jeweils Segmente einer Zylindermantelfläche mit einem Mittelpunkt an der Drehachse b, welche gleichzeitig die Längserstreckungsachse des Führungsbolzens bildet. Im zusammengesetzten Zustand bzw. im Arbeitsbereich zwischen der Dichtposition und der Grundposition einschließlich liegen die äußere Führungsfläche 14b und die innere Führungsfläche 15a jeweils flächig aneinander an und bilden ein Gleitlager für die Hubbewegung. Dabei sind sie während der Hubbewegung durchgängig miteinander in Kontakt.

In den beiden dargestellten Ausführungsbeispielen wird die Umschaltung des Anschlagstücks 17 zwischen der Sperrposition und der Freigabeposition durch eine Drehung realisiert. Dazu weist das Anschlagstück 17 zwei um 180° versetzt angeordnete und gleichartig ausgebildete Vorsprünge 17a auf. Diese stehen über den Führungsbolzen 14, insbesondere über dessen äußere Führungsfläche 14a in radialer Richtung vor - d. h. senkrecht zu der Drehachse b. In der in Fig. 3 mit durchgezogenen Linien dargestellten Sperrposition schlagen die Vorsprünge 17a an eine die Aufnahme 15 umgebende Anschlagfläche 19 an. Die Anschlagfläche 19 wird dabei durch ein Bauteil der Behälterhalterung 10, insbesondere den Träger 11 gebildet, welcher gleichzeitig die Aufnahme 15 bildet.

In der - in Fig. 3 gestrichelt dargestellten - sowie in den Figuren 4A bis 5B sichtbaren Freigabeposition fluchten die Vorsprünge 17a mit in der Aufnahme 15 ausgebildeten Durchbrüchen 15b. Dies ist insbesondere auch in den Figuren 5A und 5B erkenntlich. Dadurch, dass die Vorsprünge 17a mit den Durchbrüchen 15b fluchten, fällt die Anschlagwirkung des Anschlagstücks 17 weg. Infolgedessen kann der mit dem Anschlagstück 17 versehene Führungsbolzen 14 die Aufnahme 15 verlassen und der Dichtungsträger und die Behälterhalterung ihre relative Positionierung über den Arbeitsbereich hinaus verändern. Insbesondere kann wie z. B. in dem dargestellten Ausführungsbeispiel die Behälterhalterung 10 gänzlich abgenommen werden. Dazu steht das in dem Ausführungsbeispiel dargestellte Anschlagstück 17 ausschließlich in den Vorsprüngen 17a über den Führungsbolzen 14 nach außen vor.

In der gezeigten Variante sind mehrere, nämlich genau zwei Vorsprünge 17a umlaufend an dem Anschlagstück 17 ausgebildet. Diese sind einander gegenüberliegend und in den Abmessungen identisch ausgebildet, sodass zwei Freigabepositionen einander entgegengesetzter Orientierung existieren. Der Bereich dazwischen kann auch als Sperrbereich versehen werden, wobei mittig darin - d. h. 90° versetzt zu den beiden Freigabeposition auch eine bevorzugte Sperrposition vorgesehen ist.

In dem dargestellten Ausführungsbeispiel sind die Anschlagstücke 17 jeweils durch eine Arretierung sowohl in der Freigabeposition als auch in der Sperrposition gehalten. Hierzu sind zwei mögliche Lösungen in den Figuren 4A und korrespondierend 5A bzw. 4B und 5B dargestellt: Beide Varianten sind dabei in einer Form der Kraftbeaufschlagung ausgebildet, bei der sowohl die arretierte Sperrposition als auch die arretierte Freigabeposition durch Kraftaufwand verlassen werden kann.

Gemäß der ersten bevorzugten Ausgestaltung gemäß den Figuren 4A und 5A greift das Anschlagstück 17 den Führungsbolzen 14 an einem Abschnitt, welcher nicht-rotationssymmetrisch um die Drehachse b mit vier abgeflachten Außenflächen ausgebildet sind, welche asymmetrische (nämlich nicht-rotationssymmetrisch um die Drehachse a) Rastflächen 20 bilden. Dieser Abschnitt wird sowohl in der Sperrposition als auch in der Freigabeposition formschlüssig von dem Anschlagstück 17 umgriffen. Infolge des Formschlusses ist eine Verdrehung des Anschlagstücks gegenüber dem Führungsbolzen 14 nicht ohne Materialverlagerung möglich. In dem gezeigten Ausführungsbeispiel ist das Anschlagstück 17 elastisch und mit einem seitlichen Schlitz 21 ausgebildet, sodass sich dieses bei einer Drehbewegung elastisch verformen kann. Dabei wird der Schlitz 21 geöffnet und eine Drehbewegung trotz des Formschlusses der asymmetrischen Rastflächen 20 ermöglicht. Nach einer Drehung um einen Betrag von 90° erfolgt eine elastische Rückstellung des Anschlagstücks 17, sodass der Formschluss zwischen den Rastflächen 20 und der Innenfläche wieder hergestellt wird.

Eine weitere Möglichkeit ist in den Figuren 4B und 5B dargestellt. Wie man insbesondere der Schnittdarstellung der Fig. 5B entnehmen kann, sind in dem Anschlagstück 17, nämlich in den Vorsprüngen 17a seitlich Schraubelemente 22 angeordnet, welche in asymmetrische Rastflächen in Form von vier um 90° versetzt angeordneten Einbuchtungen 23 angeordnet sind. Je nach geometrischer Ausbildung der Einbuchtungen 23 und der Schraubelemente 22 können diese für eine formschlüssige Sperre der Drehbewegung oder alternativ für eine Kraft-beaufschlagte Arretierung verwendet werden. Im vorliegenden Ausführungsbeispiel sind die Geometrie und die Härte des Materials so aufeinander abgestimmt, dass durch Kraftbeaufschlagung eine Drehung zwischen der Sperrposition und der Freigabeposition möglich ist.

Die Schraubelemente 22 sind den zugeordneten Innengewinden der Vorsprünge 17a geführt und können so in ihre Position bzw. in ihrem Andruck an den Führungsbolzen 14 eingestellt werden.

### Bezugszeichenliste

- 1: Plasmabehandlungsanlage
- 2: Plasmabehandlungstation
- 3: Mikrowellenquelle
- 4: Kavität
- 5: Halte- und Dichtvorrichtung
- 6: Behälter
- 7: Dichtung
- 8: Dichtungsträger
- 9: Öffnung
- 10: Behälterhalterung
- 11: Träger
- 12: Halteelement
- 13: elastisches Rückstellelement
- 14: Führungsbolzen
- 14a: Nut
- 14b: äußere Anlagefläche
- 14c: Schulter
- 15: Aufnahme
- 15a: innere Anlagefläche
- 15b: Durchbruch
- 16: Federelement
- 17: Anschlagstück
- 17a: Vorsprung
- 18: Sprengring
- 19: Anschlagfläche
- 20: asymmetrische Außenfläche
- 21: seitlicher Schlitz
- 22: Schraubelement
- 23: Einbuchtung
- a: Schwenkachse
- b: Drehachse
- z: Vertikalrichtung

## Patentansprüche

1. Halte- und Dichtvorrichtung (5) zum Halten und Abdichten eines Behälters (6), insbesondere in einer Plasmabehandlungsstation (2), mit einem eine Dichtung (7) aufweisenden Dichtungsträger (8) und mit einer in einer Hubbewegung zwischen einer Grundposition und einer Dichtposition gegenüber dem Dichtungsträger (8) verlagerbaren Behälterhalterung (10) zum Halten des Behälters (6), wobei die Hubbewegung mittels zumindest eines eine Aufnahme (15) durchgreifenden Führungsbolzens (14) geführt ist, **dadurch gekennzeichnet, dass** an dem Führungsbolzen (14) zumindest ein Anschlagstück (17) angeordnet ist, welches in zumindest einer Sperrposition die Hubbewegung begrenzt und in zumindest einer Freigabeposition durch die Aufnahme (15) hindurchgeführt werden kann.

2. Halte- und Dichtvorrichtung (5) nach dem vorangegangenen Anspruch, **dadurch gekennzeichnet, dass** die Hubbewegung zwischen der Grundposition und der Dichtposition in einer Hubrichtung linear geführt ist und dass das Anschlagstück (17) durch eine Drehbewegung um eine parallel zu der Hubrichtung verlaufende Drehachse (b) zwischen der Freigabeposition und der Sperrposition bewegt werden kann.

3. Halte- und Dichtvorrichtung (5) nach einem der vorangegangenen Ansprüche, **dadurch gekennzeichnet, dass** das Anschlagstück (17) verliersicher an dem Führungsbolzen (14) gehalten ist.

4. Halte- und Dichtvorrichtung (5) nach einem der vorangegangenen Ansprüche, **dadurch gekennzeichnet, dass** der Führungsbolzen (14) eine äußere Führungsfläche (14b) aufweist, innerhalb derer der Führungsbolzen (14) als Vollbolzen mit konstantem Querschnitt ausgebildet ist, und dass die Aufnahme (15) mit einer inneren Führungsfläche (15a) flächig an der äußeren Führungsfläche (14b) anliegt und bei einer Hubbewegung zwischen der Grundposition und der Dichtposition durchgängig in Kontakt ist.

5. Halte- und Dichtvorrichtung (5) nach einem der vorangegangenen Ansprüche, **dadurch gekennzeichnet, dass** der Führungsbolzen (14) an dem Dichtungsträger (8) angeordnet ist und die Aufnahme (15) in der Behälterhalterung (10) ausgebildet ist.

6. Halte- und Dichtvorrichtung (5) nach einem der vorhergehenden Ansprüche, **dadurch gekennzeichnet, dass** der Führungsbolzen (14) an der Behälterhalterung (10) angeordnet ist und die Aufnahme in dem Dichtungsträger (8) ausgebildet ist.

7. Halte- und Dichtvorrichtung (5) nach einem der vorangegangenen Ansprüche, **dadurch gekennzeichnet, dass** das Anschlagstück (17) ein oder mehrere über den Führungsbolzen (14) nach außen vorstehende Vorsprünge (17a) aufweist, welche in der Sperrposition an eine die Aufnahme (15) umgebende Anschlagfläche (19) anschlagen und welche in der Freigabeposition mit in der Aufnahme (15) ausgebildeten Durchbrüchen (15b) fluchten.

8. Halte- und Dichtvorrichtung (5) nach dem vorangegangenen Anspruch, **dadurch gekennzeichnet, dass** das Anschlagstück (17) ausschließlich in den Vorsprüngen (17a) über den Führungsbolzen (14) nach außen vorsteht.

9. Halte- und Dichtvorrichtung (5) nach einem der beiden vorangegangenen Ansprüche, **dadurch gekennzeichnet, dass** an dem Anschlagstück (17) mehrere Vorsprünge (17a) umlaufend ausgebildet sind.

10. Halte- und Dichtvorrichtung (5) nach dem vorangegangenen Anspruch, **dadurch gekennzeichnet, dass** die Vorsprünge (17a) durch ihre Position am Umfang des Anschlagstücks (17) und/oder ihre Abmessung jeweils einem bestimmten Durchbruch (15b) zugeordnet sind.

11. Halte- und Dichtvorrichtung (5) nach einem der vorangegangenen Ansprüche, **dadurch gekennzeichnet, dass** der Führungsbolzen (14) und/oder das Anschlagstück (17) mit einem ersten Material ausgewählt aus der Gruppe Polyethylen (PE), vorzugsweise hochmolekulares Polyethylen mit einer mittleren Molmasse von zumindest 500.000 g/mol oder Polyetheretherketon(PEEK) gebildet ist und dass das die Aufnahme (15) ausbildende Teil mit einem von dem ersten Material verschiedenen zweiten Material, ausgewählt aus der Gruppe Polyethylen (PE), vorzugsweise hochmolekulares Polyethylen mit einer mittleren Molmasse von zumindest 500.000 g/mol oder Polyetheretherketon(PEEK) gebildet ist.

12. Plasmabehandlungsanlage (1) mit einer Plasmabehandlungsstation (2) und einer an die Plasmabehandlungsstation (2) angeschlossenen Mikrowellenquelle (3), **gekennzeichnet durch** eine Halte- und Dichtvorrichtung (5) nach einem der vorangegangenen Ansprüche an der Plasmabehandlungsstation (2).

13. Plasmabehandlungsanlage (1) nach dem vorangegangenen Anspruch, **dadurch gekennzeichnet, dass** die Plasmabehandlungsstation (2) zumindest eine an die Mikrowellenquelle (3) angeschlossene Kavität (4) aufweist, welche zwischen einer geschlossenen und einer geöffneten Position bewegt werden kann und dass sich die Halte- und Dichtvorrichtung (5) zumindest in der geschlossenen Position in die Kavität (4) hinein erstreckt.

14. Verfahren zur Wartung einer Halte- und Dichtvorrichtung (5) nach einem der vorangegangenen Ansprüche 1 bis 11, insbesondere in einer Plasmabehandlungsanlage (1) nach einem der beiden vorangegangenen Ansprüche, wobei die Halte- und Dichtvorrichtung (5) zum Halten und Abdichten eines Behälters (6) eingerichtet ist und einen eine Dichtung (7) aufweisenden Dichtungsträger (8) sowie eine in einer Hubbewegung zwischen einer Grundposition und einer Dichtposition gegenüber dem Dichtungsträger (8) verlagerbare Behälterhalterung (10) zum Halten des Behälters (6) umfasst, und wobei die Hubbewegung mittels zumindest eines eine Aufnahme (15) durchgreifenden Führungsbolzens (14) geführt ist, **dadurch gekennzeichnet, dass** an dem Führungsbolzen (14) zumindest ein Anschlagstück (17) angeordnet ist, welches in einer Sperrposition die Hubbewegung begrenzt und in zumindest einer Freigabeposition durch die Aufnahme (15) hindurchgeführt werden kann, dass zur Wartung zunächst das Anschlagstück (17) in die Freigabeposition bewegt wird, dass der Dichtungsträger (8) und die Behälterhalterung (10) anschließend über die Grundposition und/oder die Dichtposition hinaus bewegt werden, dass anschließend zur Wartung ein oder mehrere Baugruppen überprüft, gereinigt und/oder ausgetauscht werden, dass der Dichtungsträger (8) und die Behälterhalterung (10) anschließend in eine Position zwischen der Grundposition und der Dichtposition gebracht werden und dass abschließend das Anschlagstück (17) in die Sperrposition bewegt wird.
